# EUROPEAN PATENT SPECIFICATION

(11) **EP 1 583 147 B1**
(45) Date of publication and mention of the grant of the patent: **06.06.2012**
(21) Application number: 05250577.3
(22) Date of filing: 02.02.2005
(51) Int. Cl.: F21S 4/00, F21Y 101/02

(54) **Full-color flexible semiconductor light source device**
Flexibele Vollfarben-Halbleiterlichtquelle
Dispositif semiconducteur flexible totalement en couleur pour source de lumière

(30) Priority: 01.04.2004 CN 200410030628
(43) Date of publication of application: 05.10.2005
(73) Proprietor: Lin, Yuan, Taipei 11270 (TW)
(72) Inventor: Lin, Yuan, Taipei 11270 (TW)
(74) Representative: Lang, Christian

(56) References cited:
- EP-A2- 0 838 866
- EP-A2- 1 282 099
- EP-A2- 1 357 331
- WO-A1-2004/023033
- DE-A1- 19 608 898
- DE-U1- 20 018 865
- FR-A1- 2 833 687
- JP-A- 10 012 926
- US-A1- 2002 034 074
- US-A1- 2003 052 594
- US-A1- 2003 072 153

## Description

### BACKGROUND OF THE INVENTION

### 1. Field of The Invention

The present invention relates to light source units and more particularly to a full-color flexible light source device comprising chip on board type red, green, and blue light source units (e.g., LEDs).

### 2. Description of Related Art

A conventional light source strip comprises a plurality of LEDs (light-emitting diodes) serially coupled together in which each LED has a coupled resistor and can emit light of single color. A number of drawbacks have been found when the above light source strip is modified to become a full-color light source strip. This is because brightness difference between any two of R (red), G (green), and B (blue) LEDs is quite large. For example, brightness of three R LEDs is equal to that of one B LED. Brightness of six G LEDs is equal to that of one B LED. For obtaining a uniform brightness of the light source strip, a unit thereof is required to consist of three R LEDs, six G LEDs, and one B LED. Such arrangement (i.e., optimum spacing) is difficult of achieving. It is often that an uneven illumination is occurred on the characters and/or marks of a billboard. This is not desirable. Moreover, the size of a full-color light source strip is about three times of that of a monochromatic light source strip if the former is adapted to emit light having a brightness the same as that of the latter. Also, the circuitry of the former is complicated, resulting in an increase in the manufacturing cost. Further, heat dissipation of LED is poor. As a result, LEDs tend to malfunction.

In U.S. Pat. No. 6,540,377 there is disclosed a full-color light source unit for solving the above problem. In the patent, the above unit consisting of three R LEDs, six G LEDs, and one B LED is modified to consist of only two R LEDs, two G LEDs, and one B LED. That is, the number of LEDs has decreased from ten to five. This is an improvement. However, the light source unit is rigid as illustrated in figures thereof. Moreover, the size thereof is quite large and spacing between any two LEDs is also relatively large. All of the above are not desirable. Thus, the need for improvement still exists.

US20030072153 discloses a plurality of groups of Light Emitting Diodes (LEDs), each group being made up of three LEDs with red, green, and blue luminous colors respectively, are mounted at positioning areas of a flexible substrate, on the wiring patterns formed on the top surface of the substrate. A plurality of heat dissipation boards are adhered to the bottom surface of the substrate using an adhesive so as to cover the areas corresponding to the positioning areas of the groups of LEDs.

EP1282099 discloses a circuit for driving a self light-emitting display device which itself emits light when an electric or other energy is inputted thereto and a method thereof. According to the circuit and method, the self light-emitting display device can be driven more stably and with a higher efficiency by adjusting the number of used bits and luminance of respective color components in accordance with a luminance change of an external light and keeping a constant contrast ratio irrespective of the adjustment of the bit numbers.

JP10012926 discloses a full color emission diode lamp and display, PROBLEM TO BE SOLVED: To obtain a clear emission display surface of high uminance by realizing high density arrangement. SOLUTION: The LED lamp 10 comprises red, green and blue LED chips 11R, 11G, 11 B arranged at a constant interval in substantially regular triangle on a plane, a lead (lead frame 12), and an enclosure (resin mold) 15 formed substantially into a right prism corresponding to the three LED chips. Since the LED chips 11 R, 11G, 11 B are arranged at respective corners of the substantially regular triangular prism enclosure 15 and occupy a smallest area, an emission display surface where three primary color LED chips are arranged tightly can be formed by arranging the LED chips while abutting on the side face of the enclosure 15. The display comprises nondirectional unit dots where six full color emission LED lamps 10 are arranged adjacently in regular hexagon.

US20030052594 discloses a plurality of concaves are provided for one main surface of a flexible substrate by press-forming. Each concave has a flat surface which is substantially parallel to the main surface of the substrate, and mounted on the flat surface are three LEDs each emitting colored light of red, green, and blue respectively.

DE20018865 discloses a light system having a plurality of light sources attached on modules, wherein each module comprises means for switching and a connection with a control unit.

DE19608898 discloses a light-emitting diode (LED) device including LEDs (R1 R2; G1 G2; B1 B2) for each of the three primary colours. Alternatively it has several LEDs for each of the three primary colours. It includes a variable resistances arrangement (16r, 16q, 16b) with several variable resistors arranged on a component for each of the primary colours. The variable resistances are connected to one or several terminals of the LEDs for each of the primary colours, in order to variable control the current through the LEDs (R1 G1 B1).

EP1357331 discloses a flexible rod light device containing a string of chip on board (C.O.B.) based LED lamps (20) and manufacturing method thereof are disclosed. The device comprises an inner layer (10) including two parallel upward flanges (12,13) on sides and a lengthwise top groove (11) between the flanges; a string of C.O.B. based LED lamps (20) comprising a plurality of series connected units each including a C.O.B. based LED lamp (21) secured on the groove (11) and between the flanges (12,13), one or more conductor means (23), and a resistor (22); a pair of main wires (31,32) parallel disposed within the flanges (12,13); and a jacket (40) wrapped up the inner layer (10) and the string of lamps (20). All lamps are secured and have the same orientation for achieving an increased illumination.

US20020034074 discloses a tubular decoration light string comprising inner insulator and outer insulator, said decoration light string equipped and fixed an inner insulator, said inner insulator and decoration light string to be sealed within an outer insulator, and to form a longitudinal direction hollow in said outer insulator, increasing an effect of reflection and refraction of light.

W02004023033 discloses the invention related to LED assembly suitable to form a string provided with an LED mounted with a mounting on a base, which base is provided with electric connection wires wherein the LED mounting and electric contacts to the connection wires are protected from the surroundings by a package of hot melt material. The invention further relates to a string of interconnected LED assemblies, preferably wherein the LED assemblies are separated from each other by length of flexible contact wires.

FR2833687 discloses a decorative light chain using light-emitting diodes (LEDs), and used e.g. for window displays, comprises miniature light sources (2) each formed of at least two high performance light-emitting diodes (3) emitting light of different colors and connected into a programming circuit (6) that is integrated with the light sources and which provides independent variation of the intensity of the LEDs. Preferred Features: The LEDs (3) are mounted on an electric cable (4) connected to a power supply that includes a low-voltage transformer (6). The LEDs can be mounted on an electric cable connected to an electric cell as the power source, or multicolored LEDs that operated at 230 volts and supplied directly from the power grid can be used. Each light source can comprise a device consisting of one programming circuit and many LEDs (3) emitting different colors. Each light source can comprise three LEDs whose colors, e.g. red. green and blue, can be mixed to produce the colors of the whole range of the visible spectrum, and a programming unit provided with three outputs whose intensities vary independently in a random manner. The programming unit (6) comprises a flashing light with two or more buses as a function of the number of LEDs integrated into each light source (2). The front surface of the LED light sources is provided with an optical element (8) forming a magnifying glass.

EP0838866 discloses a system of at least three multi-coloured LED's has an optimized colour rendering index by proper selection of wavelengths of each LED, such system being useful for general illumination purposes. In a preferred embodiment, a blue LED has a wavelength in the range 455 to 490 nm, a green LED has a wavelength in the range 530 to 570 nm, and a red LED has a wavelength in the range 605 to 630 nm.

### SUMMARY OF THE INVENTION

It is an aim of the present invention to provide a full-color light source device, comprising: an inner fixing member; first, second, third, and fourth main wires disposed in the inner fixing member; a plurality of light source units coupled in series wherein a first light source unit has first, second, and third conductors extended therefrom, and a last light source unit has three fourth conductors, extended therefrom; and an outer fixing member for surrounding the inner fixing member; characterized in that: the inner fixing member is formed of a transparent or semi-transparent, flexible plastic material, the inner fixing member including a lengthwise channel therethrough; the light source unit further comprises a R LED, a G LED, and a B LED as a C.O.B. type RGB LED, the plurality of light source units are inserted into the channel; the first, second, third, and fourth main wires are parallel each other, spaced from the channel in the inner fixing member, and coupled to an external controller; the first conductor in a forward end of the first light source unit is inserted into a front end of the inner fixing member to couple to the second main wire by a tool, the second conductor in the forward end of the light source unit is inserted into the front end of the inner fixing member to couple to the third main wire by a tool, the third conductor in the forward end of the light source unit is inserted into the front end of the inner fixing member to couple to the first main wire by a tool, and the fourth conductor in a rear end of the light source unit is inserted into a rear end of the inner fixing member to couple to the fourth main wire by a tool for forming an electrical connection; the outer fixing member is made of a transparent or semi-transparent, flexible plastic material, the outer fixing member being formed by extrusion with the inner fixing member and the plurality of light source units surrounded therein; the plurality of light source units are equally spaced; and light emitted from the plurality of light source units are directed to a direction perpendicular to a surface of the outer fixing member.

The above and other objects, features and advantages of the present invention will become apparent from the following detailed description taken with the accompanying drawings.

### BRIEF DESCRIPTION OF THE DRAWINGS

FIG 1 is a perspective view of a light source unit not covered by the claims;
FIG 2 is a front plan view of the circuit board;
FIG 3 is a rear plan view of the circuit board;
FIG 4 is a perspective view of a light source device according to the invention, the light source device comprising a plurality of serially coupled light source units of FIG 1;
FIG 5 depicts the connection of a controller to the LEDs of FIG 4;
FIG. 6 is a circuit diagram of the controller;
FIG 7 is a perspective view of a preferred embodiment of light source device according to the invention;
FIG 8 is a partial exploded view of the light source device of FIG 7;
FIG 9 is a slightly enlarged view of FIG 7 with portions cut away for showing details;
FIG 10 is an exploded view of a portion of a light source device according to a second preferred embodiment of the invention; and
FIG 11 is an exploded perspective view of a light source device according to a third preferred embodiment of the invention.

### DETAILED DESCRIPTION OF THE PREFERRED EMBODIMENTS

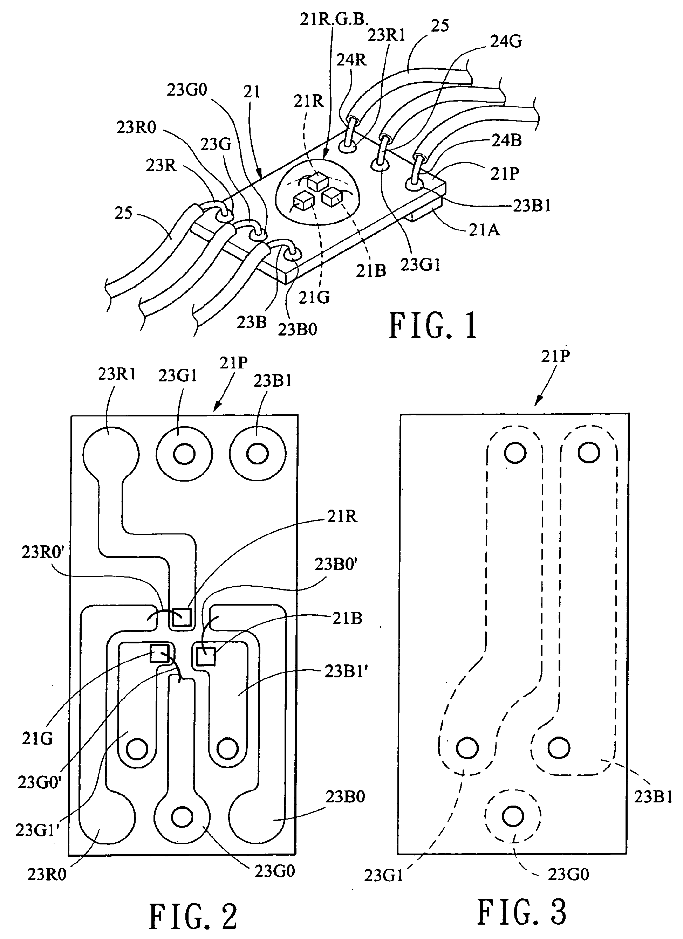

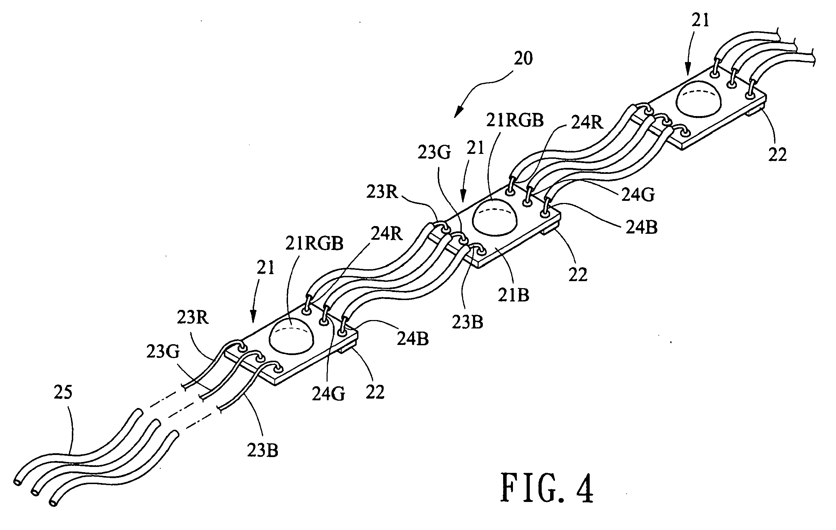

Referring to FIGS. 1 to 6, there is shown a light source device 20 constructed in accordance with a first preferred embodiment of the invention. The device 20 comprises a plurality of light source units 21 in which a first group of wires 23R, 23G, and 23B at one side of one light source unit 21 are electrically coupled to a second group of wires 24R, 24G, and 24B at the other side of an adjacent light source unit 21. This forms a serially coupled light source device including a plurality of C.O.B. (chip on board) type RGB light source units 21 (e.g., LEDs). The light source unit 21 comprises a circuit board 21P, a C.O.B. type LED 21R.G.B. Fixedly formed on the circuit board 21P, a first group of wires 23R, 23G, and 23B formed at one side, and a second group of wires 24R, 24G, and 24B formed at the other side.

In FIGS. 2 and 3, the circuit board 21P is a board having both surfaces formed with printed circuits. The wire 23R is coupled to one end of a first circuit 23R0 on the circuit board 21P. The other end of the first circuit 23R0 is coupled to a red bare chip (i.e., illuminator) 2 1 R via a conductor 23R0'. The red bare chip 2 1 R is formed on the other end of a second circuit 23R1. The wire 24R is coupled to one end of the second circuit 23R1. Similarly, the wire 23G is coupled to one end of a first circuit 23G0 on the circuit board 21P. The other end of the first circuit 23G0 is coupled to a green bare chip 21 G via a conductor 23G0'. The green bare chip 21G is formed on the other end of a second circuit 23G1'. One end of the second circuit 23G1' is coupled to the other end of a third circuit 23G1. The wire 24G is coupled to one end of the second circuit 23G1. Also, the wire 23B is coupled to one end of a first circuit 23B0 on the circuit board 21P. The other end of the first circuit 23B0 is coupled to a blue bare chip 21B via a conductor 23B0'. The blue bare chip 21B is formed on the other end of a second circuit 23B1'. One end of the second circuit 23B1' is coupled to the other end of a third circuit 23B1. The wire 24B is coupled to one end of the second circuit 23B1. This forms the electrical connection of the light source unit '21.

As shown in FIG 1, the R, G, B and blue bare chips 21R, 21G, and 21B are substantially arranged in the shape of an equiangular triangle prior to encapsulation as a C.O.B. type LED (i.e., the light source unit 21). That is, each light source unit 21 comprises a red bare chip, a green bare chip, and a blue bare chip encapsulated as a C.O.B. type LED. Moreover, the brightness ratio among red bare chip 21 R, green bare chip 21G, and blue bare chip 21B is 3:6:1 for obtaining a uniform brightness of the light source unit. Preferably, the wavelength of the red bare chip 21R is in the range of 615x10⁻⁹ to 635x10⁻⁹(ηm), the wavelength of the green bare chip 21 G is in the range of 520x10⁹ to 535x10⁻⁹( ηm), and the wavelength of the blue bare chip 21 B is in the range of 465x10⁻⁹ to 480x 10⁻⁹( ηm) respectively.

By incorporating the above three characteristics, the light source unit 21 can be formed as a single full-color light source unit 21 by including a blue bare chip 21 B, a red bare chip 21R having brightness three times of that of the blue bare chip 21B, and a green bare chip 21 G having brightness six times of that of the blue bare chip 21B. As an end, a bare chip based light source unit capable of emitting a uniform brightness from a number of light sources of different colors is embodied.

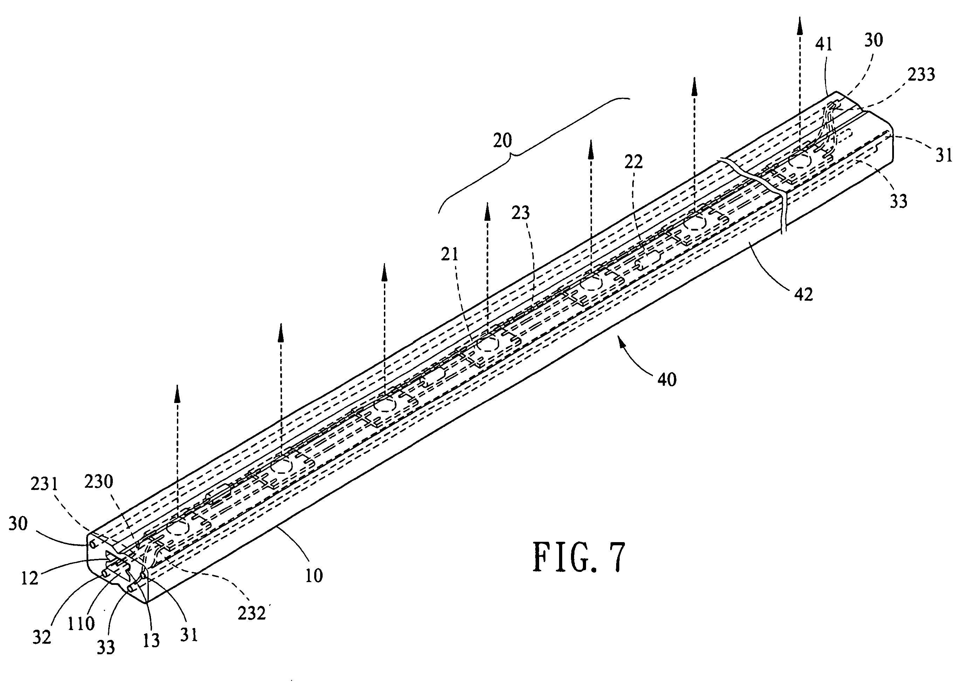

The wires 23R, 23G, and 23B coupled between two adjacent light source units 21 are bent. Further, an insulator 25 in the form of sleeve is put on each of the wires 23R, 23G, and 23B. Only the insulator 25 is fixed after extruding from an outer fixing member 40 (see FIG. 7). The wires 23R, 23G, and 23B are bent and slightly flexible so as to prevent the wires 23R, 23G, and 23B from being cut while pulling. The outer fixing member 40 will be bent when the light source device is compressed. Also, the wires 23R, 23G, and 23B may slightly contract due to its flexibility. Such enables the light source device has an increased tensile strength and flexibility while compressing.

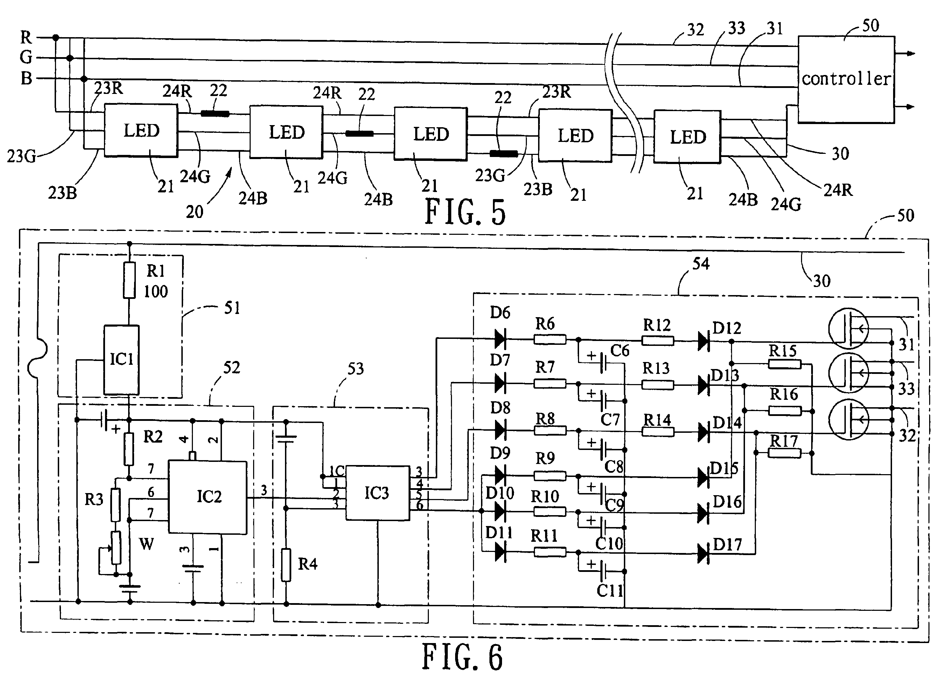

The light source device is further electrically coupled to a controller 50 which is in turn coupled to a power source. A resistor (e.g., SMD resistor) 22 (or stabilizer) is provided in each of the wires 24R, 24G, and 24B interconnected two adjacent light source units 21. Alternatively, the resistor 22 (or stabilizer) is provided in the controller 50 or any other position of the circuitry. As shown in FIG. 5, the controller 50 is a coupled to a first main wire 31, a second main wire 32, a third main wire 33, and a fourth main wire 30 of an inner fixing member 10 (see FIG 7) respectively. A ground line of the controller 50 is coupled to the fourth main wire 30 which is in turn coupled to the second group of wires 24R, 24G, and 24B respectively.

As shown in FIG 6, the controller 50 comprises a voltage stabilizer 51 including an IC (integrated circuit) IC1, an oscillator 52 including an IC IC2, a frequency divider 53 including an IC IC3, and a driving device 54 including a plurality of diodes D6 to D17, a plurality of resistors R6 to R17, a plurality of capacitors C6 to C11, and three transistors (e.g., SCRs or TRIAC_{S}). The oscillator 52 is adapted to generate an oscillating frequency which is further divided by the frequency divider 53 based on the spectrum of the RGB light source unit 21. Next, the driving device 54 is adapted to drive the RGB light source units 21 based on set time duration and time sequence. As an end, a desired light having full-color is obtained.

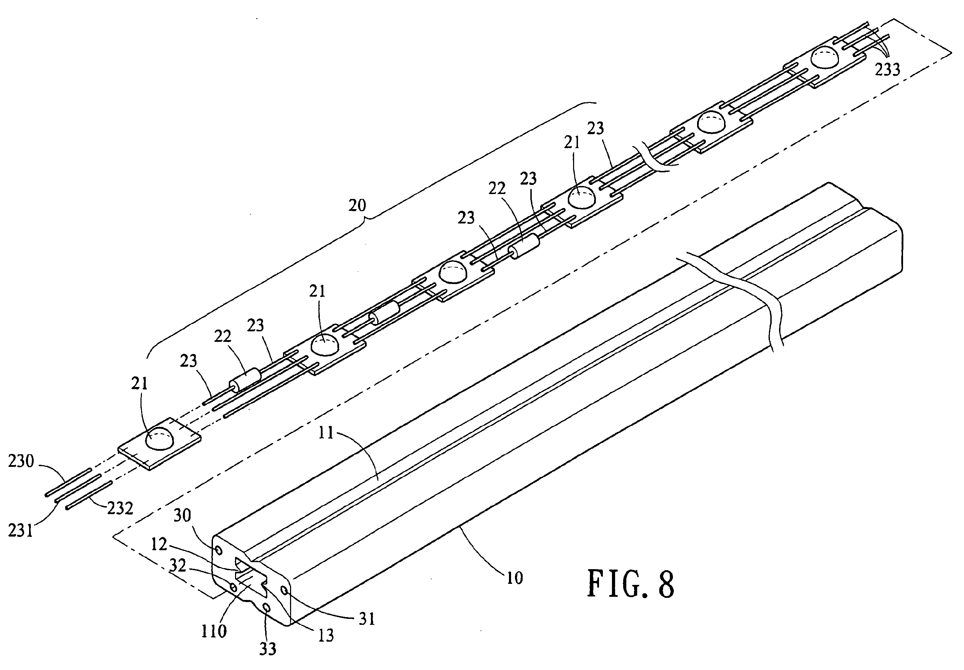

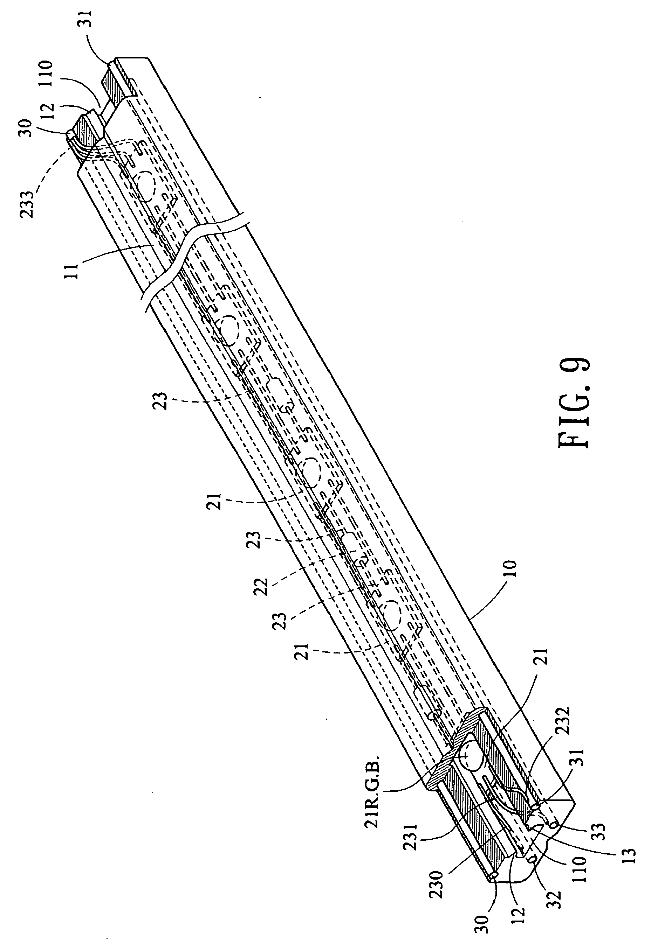

Referring to FIGS. 7 to 9, there is shown a light source device (i.e., LED strip) 20 constructed in accordance with a preferred embodiment of the invention. The device 20 is elongated and comprises a plurality of light source units 21 enclosed in an elongated, transparent or semi-transparent, flexible inner fixing member 10. First, second, third, and fourth main wires 31, 32, 33 and 30 are extended along the inner fixing member 10. The inner fixing member 10 is surrounded by an outer fixing member 40 formed of the same material as the inner fixing member 10. There is further provided a controller (not shown).

The inner fixing member 10 is formed of a plastic material. A lengthwise groove 11 is formed on a center of either top or bottom surface of the inner fixing member 10. A lengthwise channel 110 having a section of substantially hollow Z is formed in the inner fixing member 10. Two lengthwise ridges 12 and 13 are formed at both sides of the channel 110. The ridges 12 and 13 are adapted to fasten the light source device 20 in the channel 110 without any other fasteners. Each of the first, second, third, and fourth main wires 31, 32, 33 and 30 is spaced from one of four corners of the channel 110. The light source device 20 comprises a plurality of C.O.B. type LEDs 21 each having R, G, and B bare chips, three wires 23 for connecting the C.O.B. type LEDs 21 in series, and resistors 22 (or stabilizers) each disposed in one of three sections of the wires 23 between two adjacent C.O.B. type LEDs 21.

The controller (not shown) is coupled to the first, second, third, and fourth main wires 31, 32, 33 and 30. The first conductor 230 in the forward end of the light source device 20 is inserted into a front end of the inner fixing member 10 by a tool. The first conductor 230 is coupled to the second main wire 32. Similarly, the second conductor 231 in the forward end of the light source device 20 is inserted into a front end of the inner fixing member 10 by a tool. The second conductor 231 is coupled to the third main wire 33. The third conductor 232 in the forward end of the light source device 20 is inserted into a front end of the inner fixing member 10 by a tool. The third conductor 232 is coupled to the first main wire 31. The fourth conductor 233 in the rear end of the light source device 20 is inserted into the rear end of the inner fixing member 10 via the channel 110 by a tool. The fourth conductor 233 is coupled to the fourth main wire 30. This completes the electrical connection.

The outer fixing member 40 is formed by extrusion. The inner fixing member 10 and the light source device 20 are encapsulated in an airtight environment so as to form a light source strip having increased tensile strength and flexibility and being waterproof and vibration-proof. A top or bottom surface of the outer fixing member 40 is flat. Further, the light source device 20 is in turn controlled by the controller 50 for causing the C.O.B. type RGB light source units 21 to emit light with uniform full-color.

The flat top and bottom surfaces of the outer fixing member 40 facilitates the light source device to mount on an object and fasten thereat. Also, light is emitted in a direction perpendicular to the surface of the outer fixing member 40 for obtaining an increased brightness. The light source device 20 is adapted to bend without adversely affecting light emission. This is because, as stated above, the light source device has increased tensile strength and flexibility.

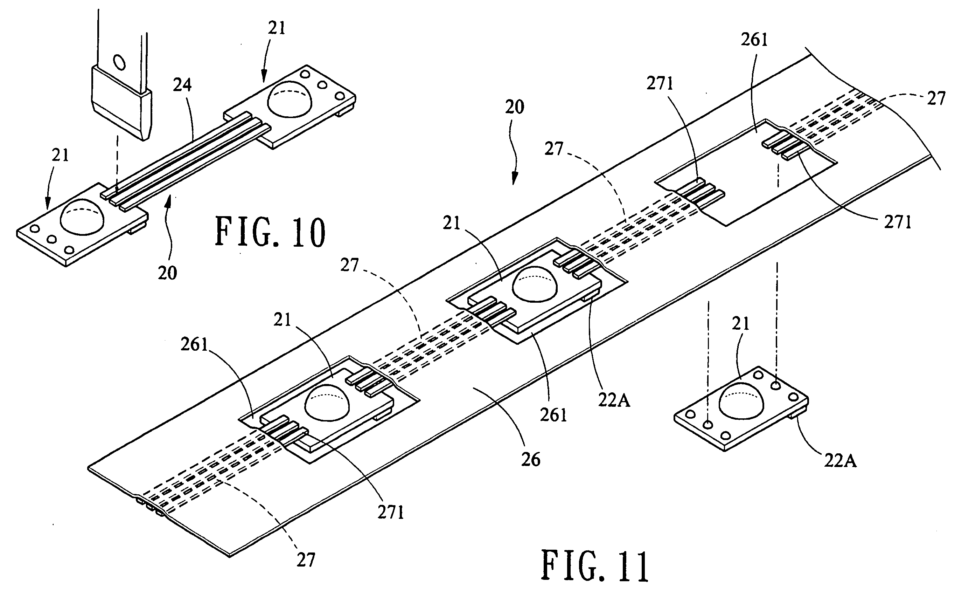

Referring to FIG 10, there is shown a light source device 20 constructed in accordance with a second preferred embodiment of the invention. The characteristic of the third preferred embodiment is that three copper wires 24 are interconnected two adjacent C.O.B. type RGB LEDs 21 by soldering.

Referring to FIG 11, there is shown a light source device 20 constructed in accordance with a third preferred embodiment of the invention. In the manufacturing process, the device 20 is first placed on an elongated, flexible sheet 26. The sheet 26 comprises a plurality of equally spaced rectangular openings 261 for receiving the C.O.B. type RGB LEDs 21 having a SMD (surface mounting) resistor 22A on its bottom. Three sections of conductive metal wires 27 are disposed between two adjacent openings 261 in which both ends 271 of the wires 27 are exposed for coupling to the C.O.B. type RGB LEDs 21 by soldering. Next, remove the sheet 26 with the light source device 20 fixedly formed in the inner fixing member. Such can provide an equal spacing between any two adjacent light source units 21 for facilitating mass production.

Note that the sheet 26 and the conductive metal wires 27 can be formed as a peeling strip. Further, the plurality of openings 261 are formed by punching on the sheet 26. The conductive metal wires 27 are also cut into a plurality of sections each having two exposed ends 271. Next, turn the peeling strip upside down so that the C.O.B. type RGB LED 21 can be fixedly coupled between two adjacent wires 27 for forming a serially coupled light source device 20.

Further note that the connection of the C.O.B. type RGB LEDs 21 and the wires 27 can be done by a plurality of soldering in one time for saving time and cost in mass production.

While the invention herein disclosed has been described by means of specific embodiments, numerous modifications and variations could be made thereto by those skilled in the art without departing from the scope of the invention set forth in the claims.

## Claims

1. A full-color light source device (20), comprising:
an inner fixing member (10);
first, second, third, and fourth main wires (31, 32, 33, 30) disposed in the inner fixing member (10);
a plurality of light source units (21) coupled in series wherein a first light source unit (21) has first, second, and third conductors (230, 231, 232) extended therefrom, and a last light source unit has three fourth conductors (233), extended therefrom; and
an outer fixing member (40) for surrounding the inner fixing member (10); wherein
the inner fixing member (10) is formed of a transparent or semi-transparent, flexible plastic material, the inner fixing member (10) including a lengthwise channel (110) therethrough;
the light source unit (21) further comprises a R LED, a G LED, and a B LED as a C.O.B. type RGB LED, the plurality of light source units (21) are inserted into the channel (110);
the first, second, third, and fourth main wires (31, 32, 33, 30) are parallel each other, spaced from the channel (110) in the inner fixing member (10), and coupled to an external controller (50);
the first conductor (230) in a forward end of the first light source unit (21) is inserted into a front end of the inner fixing member (10) to couple to the second main wire (32) by a tool, the second conductor (231) in the forward end of the light source unit (21) is inserted into the front end of the inner fixing member (10) to couple to the third main wire (33) by a tool, the third conductor (232) in the forward end of the light source unit (21) is inserted into the front end of the inner fixing member (10) to couple to the first main wire (31) by a tool, and the fourth conductor (233) in a rear end of the light source unit (21) is inserted into a rear end of the inner fixing member (10) to couple to the fourth main wire (30) by a tool for forming an electrical connection;
the outer fixing member (40) is made of a transparent or semi-transparent, flexible plastic material, the outer fixing member (40) being formed by extrusion with the inner fixing member (10) and the plurality of light source units (21) surrounded therein;
the plurality of light source units (21) are equally spaced; and
light emitted from the plurality of light source units (21) are directed to a direction perpendicular to a surface of the outer fixing member (40).

2. The full-color light source device of claim 1, wherein the channel (110) has a cross section substantially in the form of a Z and comprises two lengthwise ridges (12, 13) at both sides so that the light source device (20) is adapted to fasten in the channel (110) without any other fasteners.

3. The full-color light source device of claim 1, wherein the light source unit (21) comprises a SMD resistor (22) and conductors, and the light source unit (21) is disposed on a circuit board for reducing circuitry, and the SMD resistor (22) comprises a plurality of ICs or current control ICs.

4. The full-color light source device of claim 1, wherein the light source unit (21) comprises a SMD resistor (22) and three copper wires (24) connected to an adjacent light source unit (21) by soldering, and the SMD resistor (22) comprises a plurality of ICs or current control ICs.

5. The full-color light source device of claim 1, wherein the light source unit (21) comprises a SMD resistor (22) or current stabilizer and two adjacent light source units (21) are electrically coupled together by three wire sections (23) by soldering, further comprising a hollow, cylindrical insulator put on each wire section so that responsive to extruding the insulator from the outer fixing member (40) the insulator is fixed and the wire sections are bent and flexible, and the SMD resistor (22) comprises a plurality of ICs or current control ICs.

6. The full-color light source device of claim 1, further comprising a peeling strip including a sheet including a plurality of equally spaced openings, and a plurality of conductive metal wire (27) sections each having both ends (271) exposed, and wherein the light source unit (21) is disposed in the opening, and the exposed ends (271) of the conductive metal wire (27) sections are interconnected two adjacent light source units (21) by soldering.

7. The full-color light source device of claim 6, wherein the light source unit (21) is disposed on a circuit board having a SMD resistor (22) coupled to the light source unit (21), and the SMD resistor (22) comprises a plurality of ICs or current control ICs.

8. The full-color light source device of claim 7, further comprising a peeling strip including a sheet including a plurality of equally spaced openings by punching, and a conductive metal wire (27) cut into a plurality of wire sections by cutting, and wherein each wire section has both ends (271) exposed, the light source unit (21) is disposed in the opening, and the exposed ends (271) of the conductive metal wire (27) sections are interconnected two adjacent light source units (21) by soldering after turning the peeling strip upside down.

9. The full-color light source device of claim 6, wherein the sheet of the peeling strip is secured to the inner fixing member (10) by adhering.

10. The full-color light source device of claim 1, wherein the outer fixing member (40) is formed by extrusion with the inner fixing member (10) and the light source units (21) encapsulated therein so as to have increased tensile strength and flexibility and be waterproof and vibration-proof.

## Patentansprüche

1. Vollfarb-Lichtquellenvorrichtung (20), umfassend:
- ein inneres Befestigungselement (10);
- erste, zweite, dritte und vierte Hauptdrähte (31, 32, 33, 30), die im inneren Befestigungselement (10) angeordnet sind;
- eine Mehrzahl von Lichtquelleneinheiten (21), die in Serie geschaltet sind, wobei eine erste Lichtquelleneinheit (21) erste, zweite und dritte Leiter (230, 231, 232) aufweist, die sich von da aus erstrecken, wobei eine letzte Lichtquelleneinheit drei vierte Leiter (233) aufweist, die sich von da aus erstrecken; und
- ein äußeres Befestigungselement (40), das zum Umschließen des inneren Befestigungselements (10) dient,
**dadurch gekennzeichnet,**
**dass** das innere Befestigungselement (10) aus einem durchsichtigen oder halbdurchsichtigen, flexiblen Kunststoff ausgebildet ist, wobei das innere Befestigungselement (10) einen Kanal (110), der durch das innere Befestigungselement (10) längs verläuft, umfasst;
**dass** die Lichtquelleneinheit (21) weiter eine R-LED, eine G-LED und eine B-LED aufweist, wobei die R-, die G- und die B-LED als eine RGB-LED des C.O.B-Typs gebildet sind, wobei die Mehrzahl von Lichtquelleneinheiten (21) in den Kanal (110) eingesetzt ist;
**dass** die ersten, die zweiten, die dritten und die vierten Hauptdrähte (31, 32, 33, 30) parallel zueinander, vom Kanal (110) im inneren Befestigungselement (10) beabstandet angeordnet und mit einem externen Controller (50) gekoppelt sind;
**dass** der erste Leiter (230) in einem vorderen Ende der ersten Lichtquelleneinheit (21) in ein Frontende des inneren Befestigungselements (10) eingesetzt wird, um sich durch ein Werkzeug mit dem zweiten Hauptdraht (32) zu koppeln, wobei der zweite Leiter (231) im vorderen Ende der Lichtquelleneinheit (21) ins Frontende des inneren Befestigungselements (10) eingesetzt wird, um sich durch ein Werkzeug mit dem dritten Hauptdraht (33) zu koppeln, wobei der dritte Leiter (232) im vorderen Ende der Lichtquelleneinheit (21) ins Frontende des inneren Befestigungselements (10) eingesetzt wird, um sich durch ein Werkzeug mit dem ersten Hauptdraht (31) zu koppeln, und wobei der vierte Leiter (233) im hinteren Ende der Lichtquelleneinheit (21) in ein Rückende des inneren Befestigungselements (10) eingesetzt wird, um sich durch ein Werkzeug mit dem vierten Hauptdraht (30) zu koppeln und **dadurch** eine elektrische Verbindung herzustellen;
**dass** das äußere Befestigungselement (40), das aus einem durchsichtigen oder halbdurchsichtigen, flexiblen Kunststoff ausgebildet ist, wobei das äußere Befestigungselement (40) durch Extrudieren mit dem inneren Befestigungselement (10) und der Mehrzahl von darin eingeschlossenen Lichtquelleneinheiten (21) ausgebildet ist;
**dass** die Mehrzahl von Lichtquelleneinheiten (21) in einem gleichen Abstand zueinander angeordnet ist; und
**dass** aus der Mehrzahl von Lichtquelleneinheiten (21) emittiertes Licht zu einer senkrecht zu einer Oberfläche des äußeren Befestigungselements (40) verlaufenden Richtung geleitet wird.

2. Vollfarb-Lichtquellenvorrichtung nach Anspruch 1,
**dadurch gekennzeichnet,**
**dass** der Kanal (110) einen wesentlich Z-förmigen Querschnitt aufweist und an beiden Seiten zwei längsgerichtete Rippen (12, 13) umfasst, mit denen die Lichtquellenvorrichtung (20) ohne weitere Befestigungselemente im Kanal (110) befestigt werden kann.

3. Vollfarb-Lichtquellenvorrichtung nach Anspruch 1,
**dadurch gekennzeichnet,**
**dass** die Lichtquelleneinheit (21) einen SMD-Widerstand (22) und Leiter umfasst, wobei die Lichtquelleneinheit (21) zum Zwecke der Reduzierung der Schaltungsanordnung auf einer Platine angeordnet ist, wobei der SMD-Widerstand (22) eine Mehrzahl von integrierten Schaltungen oder integrierten Schaltungen für Stromregelung umfasst.

4. Vollfarb-Lichtquellenvorrichtung nach Anspruch 1,
**dadurch gekennzeichnet,**
**dass** die Lichtquelleneinheit (21) einen SMD-Widerstand (22) und drei Kupferdrähte (24) umfasst, die durch Löten an eine benachbarte Lichtquelleneinheit (21) angeschlossen werden, wobei der SMD-Widerstand (22) eine Mehrzahl von integrierten Schaltungen oder integrierten Schaltungen für Stromregelung umfasst.

5. Vollfarb-Lichtquellenvorrichtung nach Anspruch 1,
**dadurch gekennzeichnet,**
**dass** die Lichtquelleneinheit (21) einen SMD-Widerstand (22) oder Stromstabilisator umfasst und zwei benachbarte Lichtquelleneinheiten (21) durch Löten mittels von drei Drahtabschnitten (23) miteinander elektrisch gekoppelt werden, wobei die Lichtquelleneinheit (21) ferner einen hohlen, zylinderförmigen Isolator umfasst, der an jeden Drahtabschnitt gesetzt ist, so dass durch Extrudieren des Isolators aus dem äußeren Befestigungselement (40) der Isolator befestigt wird und die Drahtabschnitte gebogen und flexibel werden, wobei die SMD-Widerstand (22) eine Mehrzahl von integrierten Schaltungen oder integrierten Schaltungen für Stromregelung umfasst.

6. Vollfarb-Lichtquellenvorrichtung nach Anspruch 1, die ferner einen Schälband, das ein Blatt mit einer Mehrzahl von gleichmäßig beabstandet angeordneten Öffnungen umfasst, und eine Mehrzahl von Abschnitten eines leitfähigen Metalldrahtes (27), welche Abschnitte jeweils zwei freigelegte Enden (271) aufweisen, umfasst,
**dadurch gekennzeichnet,**
**dass** die Lichtquelleneinheit (21) in der Öffnung angeordnet ist und dass die freigelegten Enden (271) der Abschnitte des leitfähigen Metalldrahtes (27) durch Löten mit zwei benachbarten Lichtquelleneinheiten (21) zusammengeschaltet werden.

7. Vollfarb-Lichtquellenvorrichtung nach Anspruch 6,
**dadurch gekennzeichnet,**
**dass** die Lichtquelleneinheit (21) auf einer Platine angeordnet, die einen SMD-Widerstand (22) aufweist, der mit der Lichtquelleneinheit (21) gekoppelt ist, wobei der SMD-Widerstand (22) eine Mehrzahl von integrierten Schaltungen oder integrierten Schaltungen für Stromregelung umfasst.

8. Vollfarb-Lichtquellenvorrichtung nach Anspruch 7,
**dadurch gekennzeichnet,**
**dass** die ferner ein Schälband, das ein Blatt mit einer Mehrzahl von durch Stanzen gleichmäßig beabstandet angeordneten Öffnungen und einen durch Schneiden in eine Mehrzahl von Drahtabschnitten geschnittenen leitfähigen Metalldraht (27) umfasst,
**dadurch gekennzeichnet,**
**dass** jeder Drahtabschnitt zwei freigelegte Enden (271) aufweist; dass die Lichtquelleneinheit (21) in der Öffnung angeordnet ist; und dass die freigelegten Enden (271) der Abschnitte des leitfähigen Metalldrahtes (27) nach dem Umdrehen des Schälbandes durch Löten mit zwei benachbarten Lichtquelleneinheiten (21) zusammengeschaltet werden.

9. Vollfarb-Lichtquellenvorrichtung nach Anspruch 6,
**dadurch gekennzeichnet,**
**dass** das Blatt des Schälbandes durch Kleben am inneren Befestigungselement (10) befestigt wird.

10. Vollfarb-Lichtquellenvorrichtung nach Anspruch 1,
**dadurch gekennzeichnet,**
**dass** das äußere Befestigungselement (40) durch Extrudieren mit dem inneren Befestigungselement (10) und den darin eingekapselten Lichtquelleneinheiten (21) ausgebildet ist, um eine erhöhte Festigkeit und Flexibilität zu erhalten und wasserdicht sowie erschütterungsfest zu sein.

## Revendications

1. Dispositif (20) d'éclairage en couleur, comprenant:
un élément de fixation intérieur (10);
un première, deuxième, troisième, et quatrième fil principal (31, 32, 33, 30) disposé dans l'élément de fixation intérieur (10);
une pluralité d'unités d'éclairage (21) couplées en série de telle sorte qu'une première unité d'éclairage (21) comporte un premier, deuxième et troisième conducteur (230, 231, 232), dans son prolongement et que la dernière unité d'éclairage a trois quatrièmes conducteurs ( 233), dans le prolongement de celle-ci, et
un élément de fixation extérieur (40) pour entourer l'élément de fixation intérieur (10);
dans lequel :
l'élément de fixation intérieur (10) est formée d'une matière plastique souple, transparente ou semi-transparente, l'élément de fixation intérieur (10) comprenant un canal longitudinal (110) le traversant;
l'unité d'éclairage (21) comprend en outre une diode R, une diode V et une diode B installées pour réaliser un montage direct des puces de type RVB, la pluralité d'unités d'éclairage (21) est insérée dans le canal (110);
le première, deuxième, troisième et quatrième fil principal (31, 32, 33, 30) sont parallèles entre eux, éloignés du canal (110) dans l'élément de fixation intérieur (10), et couplés à un contrôleur externe (50) ;
le premier conducteur (230) dans une extrémité avant de l'unité d'éclairage (21) est inséré dans une extrémité avant de l'élément de fixation intérieur (10) pour se coupler au second fil principal (32) avec un outil, le second conducteur (231) dans l'extrémité avant de l'unité d'éclairage (21) est inséré dans l'extrémité avant de l'élément de fixation intérieur (10) pour se coupler au troisième
fil principal (33) avec un outil, le troisième conducteur (232) dans l'extrémité avant de l'unité d'éclairage (21) est inséré dans l'extrémité avant de l'élément de fixation intérieur (10) pour se coupler au premier fil principal (31) avec un outil, et le quatrième conducteur (233) dans une extrémité arrière de l'unité d'éclairage (21) est inséré dans une extrémité arrière de l'élément de fixation intérieur (10) pour se coupler au quatrième fil principal (30) avec un outil, pour former une connexion électrique;
l'élément de fixation extérieur (40) est fait dans une matière plastique souple, transparent ou semi-transparent, l'élément de fixation extérieur (40) étant formé par extrusion par rapport à l'élément de fixation intérieur (10) et la pluralité d'unités d'éclairage (21) entourée à l'intérieur;
la pluralité d'unités d'éclairage (21) est espacée de manière égale, et
la lumière émise par la pluralité d'unités d'éclairage (21) est dirigée vers une direction perpendiculaire à une surface de l'élément de fixation extérieur (40).

2. Le dispositif d'éclairage en couleur selon la revendication 1, dans lequel le canal (110) présente une section transversale globalement en forme d'un Z et comprend deux saillieslongitudinales (12, 13) des deux côtés de sorte que le dispositif d'éclairage (20) est adapté pour se fixer dans le canal (110) sans aucune autre sorte de fixation.

3. Le dispositif d'éclairage en couleur selon la revendication 1, dans lequel l'unité d'éclairage (21) comprend une résistance CMS (22) et des conducteurs, et l'unité d'éclairage (21) est disposée sur une carte de circuit imprimé pour réduire l'ensemble de circuits, et la résistance CMS (22) comprend une pluralité de CI ou CI de réglage du courant.

4. Le dispositif d'éclairage en couleur selon la revendication 1, dans lequel l'unité d'éclairage (21) comprend une résistance CMS (22) et et trois fils de cuivre (24) reliés à une unité d'éclairage (21) adjacente, par brasage, et la résistance CMS (22) comprend une pluralité de CI ou CI de réglage du courant.

5. Le dispositif d'éclairage en couleur selon la revendication 1, dans lequel l'unité d'éclairage (21) comprend une résistance CMS (22) ou un stabilisateur de courant et deux unités d'éclairage (21) adjacentes qui sont couplés électriquement entre elles par trois sections de fil (23), par brasage, comprenant en outre un isolant cylindrique creux placé sur chaque sections de fil de telle sorte qu'il soit capable de réponse à l'extrusion de l'isolateur par rapport à l'élément de fixation extérieur (40), l'isolateur est fixe et les sections de fil sont pliées et flexibles, et la résistance CMS (22) comprend une pluralité de circuits intégrés ou des ICs de réglage du courant.

6. Le dispositif d'éclairage en couleur selon la revendication 1, comprenant en outre une bande de décollage comprenant une feuille ayant une pluralité d'ouvertures espacées de manière égale, et une pluralité de sections de fils en métal conducteur (27) ayant chacun deux extrémités (271) exposées, et dans lequel l'unité d'éclairage (21) est disposée dans l'ouverture, et les extrémités exposées (271) des sections de fil en métal conducteur (27) relient entre elles deux unités d'éclairage (21) adjacentes, par brasage.

7. Le dispositif d'éclairage en couleur selon la revendication 6, dans lequel l'unité d'éclairage (21) est disposé sur une carte de circuit imprimé ayant une résistance CMS (22) couplée à l'unité d'éclairage (21), et la résistance CMS (22) comprend une pluralité de circuits intégrés ou des ICs de réglage du courant.

8. Le dispositif d'éclairage en couleur selon la revendication 7, comprenant en outre une bande de décollage comprenant une feuille ayant une pluralité d'ouvertures espacées de manière égale par poinçonnage, et un fil en métal conducteur (27) découpé en une pluralité de sections de fil par découpage, et dans lequel chaque section de fils a deux extrémités (271) exposées, l'unité d'éclairage (21) est disposée dans l'ouverture, et les extrémités exposées (271) des sectionis du fil en métal conducteur (27) relient entre elles deux unités d'éclairage (21) adjacentes, par brasage, après avoir retourné la bande de décollage.

9. Le dispositif d'éclairage en couleur selon la revendication 6, dans lequel la feuille de la bande de décollage est fixée à l'élément de fixation intérieur (10) par collage.

10. Le dispositif d'éclairage en couleur selon la revendication 1, dans lequel l'élément de fixation extérieur (40) est formée par extrusion avec l'élément de fixation intérieur (10) et les unités d'éclairage (21) sont encapsulé à l'intérieur de manière à augmenter la résistance à la traction et la flexibilité et être imperméable et résistant aux vibrations.
